Europäisches Patentamt

European Patent Office

Office européen des brevets

(19)

(11) Publication number: **0 456 388 A1**

# EUROPEAN PATENT APPLICATION

(12)

(21) Application number: **91303782.6**

(22) Date of filing: **26.04.91**

(51) Int. Cl.⁵: **H01L 21/00**

(30) Priority: **08.05.90 US 520432**

(43) Date of publication of application:
**13.11.91 Bulletin 91/46**

(84) Designated Contracting States:
**DE FR GB**

(71) Applicant: **International Business Machines Corporation**
**Old Orchard Road**
**Armonk, N.Y. 10504 (US)**

(72) Inventor: **Adair, William Wesley**
**9304 Spring Hollow Drive**
**Austin, Texas 78750 (US)**
Inventor: **Frankeny, Jerome Albert**
**516 West 7th Street**
**Taylor, Texas 76574 (US)**

(74) Representative: **Killgren, Neil Arthur**
**IBM United Kingdom Limited Intellectual**
**Property Department Hursley Park**
**Winchester Hampshire SO21 2JN (GB)**

(54) **Processing high-density circuit substrates and container for use in such processing.**

(57) A high-density circuit substrate is housed in cassettes 52,54 which seal out deleterious contaminants to the substrate during processing, storage and transportation, thereby obviating necessity for clean-room environments. Substrate material is fed into and out of the cassette through a sealing aperture defined by and disposed through the housing wall. In use, a first feed cassette is releasably attached to a substrate processing apparatus which feeds raw substrate material, by means of a drive bushing on the spool, into the apparatus for punching, dielectric application, and the like. A second take-up cassette returns the thus-processed substrate into the cassette, again by means of rotation of the drive bushing, for storage and subsequent further manufacturing operations, wherein the take-up cassette is detached from the processing apparatus. The opposing inner faces of the housing are provided with symmetrical opposing spiraling grooves. When the substrate material is introduced into or pulled from the cassette, its edges travel in respective ones of these grooves. In this manner, the coil is maintained within the housing with a minute spatial separation between layers in the radial direction.

FIG. 5

This invention relates to electronic circuit manufacture and, more particularly, to the processing of high density circuit substrates.

In electronic circuit manufacture, it has long been customary to feed components for attachment to a circuit from rolls or tapes. Specially configured machines individually strip such components from the advancing tape for installation in the circuit as required. Initially, this technique was primarily limited to discrete components, wherein, for example, a roll of leaded discrete resistors of identical value were provided. These components would be picked off the feed tape by robotic arms and thence placed on the circuit at the desired location, such machines being generally known in the industry as pick-and-place machines. A plurality of such rolls are typically provided so that numerous different components could be placed in the circuit. Representative examples of machines employing such component rolls or tapes and their application in the hereinbefore described manufacturing processes may be seen by reference to details of, for example, MPS 500 and MPS 2500 component placement machines and MK1 placement machines manufactured by the Dynapert and Panasonic corporations, respectively.

As the art continued to mature and electronic miniaturization increased, it was recognized that not only could individual components be provided on a tape, but entire subassemblies including integrated circuits and the like. These subassemblies, as in the case of the discrete component counterparts, could be separated from the tape and installed in yet a larger electronic circuit in like manner to the placement of the discrete components with suitable apparatus. One form of this manufacturing process has been referred to in the industry as tape automated bonding or TAB. Representative machines for effecting this manufacturing process may be seen in the TAB machines manufactured by the Jade Corporation and the Farco Corporation, with the roll or tape of the circuits which are severed and subsequently installed being described in more detail with reference to documentation associated with these machines.

It will be noted with respect to the discrete component and TAB technology hereinbefore described that such rolls were provided in open reels. The subcircuit assemblies and components being provided in the roll form typically had already been completely manufactured and, thus, only awaited installation at the appropriate situs. Maintenance of a clean environment while in the rolled form was, thus, of little concern inasmuch as the manufacturing operations on the components and subcircuits on the tapes or rolls had long since been completed and they simply awaited installation.

As manufacturing processes have improved, resulting in increased miniaturization, complex electronic circuits have been manufactured on substrates referred to as high-density carriers which take the form of elongate sheets on which circuits are replicated over and over in line. However, unlike the aforementioned discrete component roll and TAB processes, such high-density manufacturing techniques generally demand extremely pure environments, and it is conventional to use clean-rooms wherein the entire manufacturing process, from start to finish, is conducted.

Several problems are associated with this necessity for clean-rooms. First, such clean environments are extremely difficult to design and maintain, particularly as the size of the room and volume of air to be maintained increase. Secondly, it is not always possible to provide all the necessary manufacturing operations for the particular substrate in question within the same large clean-room. Accordingly, serious problems arose in effecting the transportation of such substrates at an intermediate point in the manufacturing process to another clean-room site while avoiding contamination of the intermediate product.

Yet an additional problem arising from the very thin nature of certain strips of substrates, circuits and components, resulted in the inability to provide such strips in roll form which, if otherwise possible, could substantially aid various manufacturing and packaging processes associated with such strips. Many of these strips have a nominal thickness of only 2 to 5 mils, often have delicate thin coatings such photoresists disposed thereon. As a result, they must not contact one another in order to preserve their integrity. Nor is their resistance to compressibility in the longitudinal direction of the strip very substantial, rendering it difficult to form them into rolls.

It is accordingly an object of the present invention to provide an improved processing apparatus and method which permits not only storing raw and completed substrates, but also the resumption of manufacturing processes on a substrate with a minimum of problems.

According to the invention we provide a container for high-density circuit substrate material for use with apparatus for processing said substrate, comprising support means for supporting said material in the form of a coil and a housing for sealably housing said coil, said housing including means for retaining layers of said coil in radially spaced apart relation.

We further provide a circuit substrate processing apparatus comprising a feed cassette including a coil of high-density substrate material; a take-up cassette including a coil of said high-density substrate-material; and substrate processing means for processing said substrate material when extended between said feed and said take-up cassettes.

We further provide a method for processing a high-density circuit substrate on a substrate processing apparatus, comprising establishing a feed rool and a take-up roll of said high-density substrate; feeding a length of said high-density substate from said feed roll to said take-up roll; and performing a substrate processing operation on said length of said high-density substrate while interconnected to said feed roll and said take-up roll.

A preferred form of cassette embodying the invention includes a cylindrical housing enclosing a coil of high-density carrier film strip material disposed about a take-up spool. The housing seals out deleterious contaminants to the strip during processing, storage and transportation, thereby obviating necessity for clean-room environments. Film is fed into and out of the cassette through a sealing aperture defined by and disposed through the housing wall. In use, a first feed cassette is releasably attached to a substrate processing apparatus which feeds raw substrate material, by means of a drive bushing on the spool, into the apparatus for punching, dielectric application, and the like. A second take-up cassette returns the thus-processed substrate into the cassette, again by means of rotation of the drive bushing, for storage and subsequent further manufacturing operations, wherein the take-up cassette is detached from the processing apparatus. The opposing inner faces of the housing are provided with symmetrical opposing spiraling grooves. When the strip is introduced into or pulled from the cassette, the edges of the strip travel in respective ones of these grooves. In this manner, the coil of the strip is maintained within the housing with a minute spatial separation between each layer of the strip in the radial direction.

In order that the invention may be well understood, the preferred forms of container, together with a preferred apparatus and method for putting the invention into effect, will now be described with reference to the accompanying drawings, in which:

Fig. 1 is a front view of the substrate cassette of the present invention;

Fig. 2 is a side view of the cassette of Fig. 1;

Fig. 3 is a sectional view of another embodiment of the cassette of Fig. 1 taken along 3-3 of Fig. 1;

Fig. 4 is a view partly in section of another embodiment of the cassette of Fig. 2 taken along 4-4 of Fig. 2;

Fig. 5 is a representative multi-tool substrate processing apparatus illustrating application of multiple cassettes of Fig. 1 in a method for processing substrates contained therein; and

Fig. 6 is an expanded view of a portion of the cassette in Fig. 4.

## Best Mode for Carrying Out the Invention

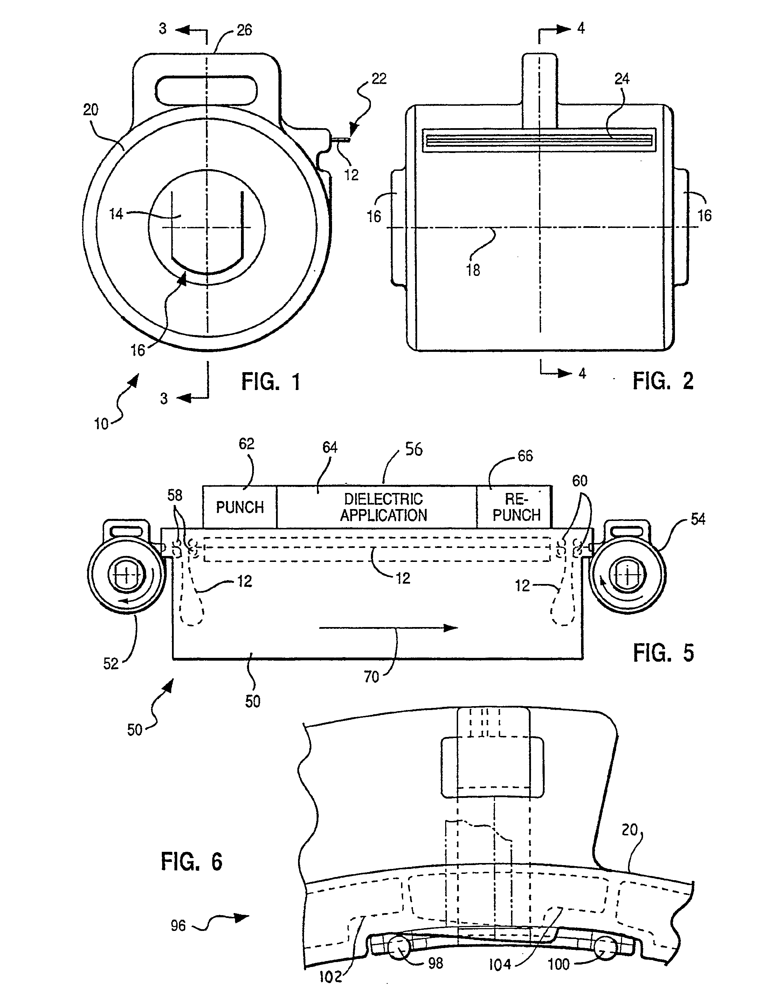

Referring first to Fig. 1, a front view of the substrate cassette 10 of the present invention is shown depicted therein. The cassette 10 includes a cylindrically shaped housing 20 which encloses a substrate strip 12 coiled about a spool 14 which rotates about the axis 18 (Fig. 2) which extends through the center of the housing 20.

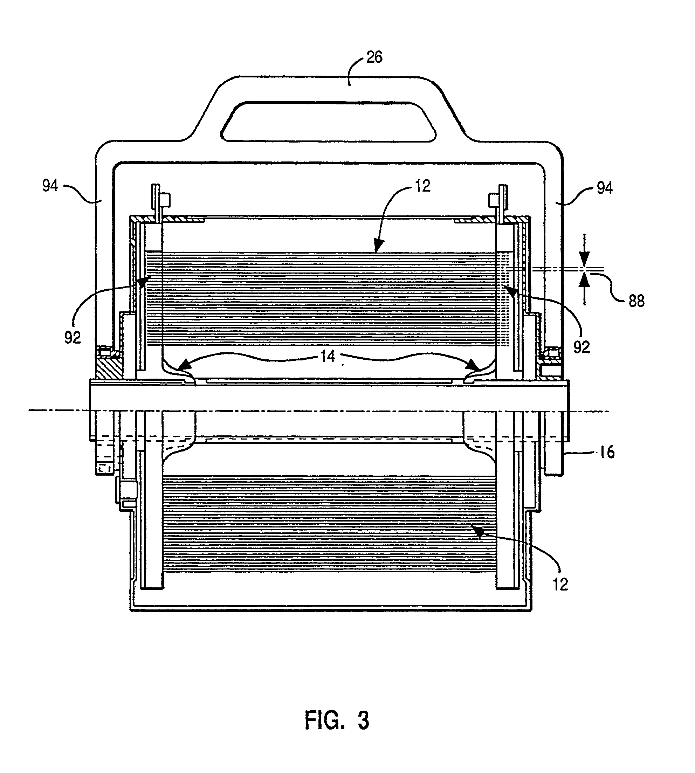

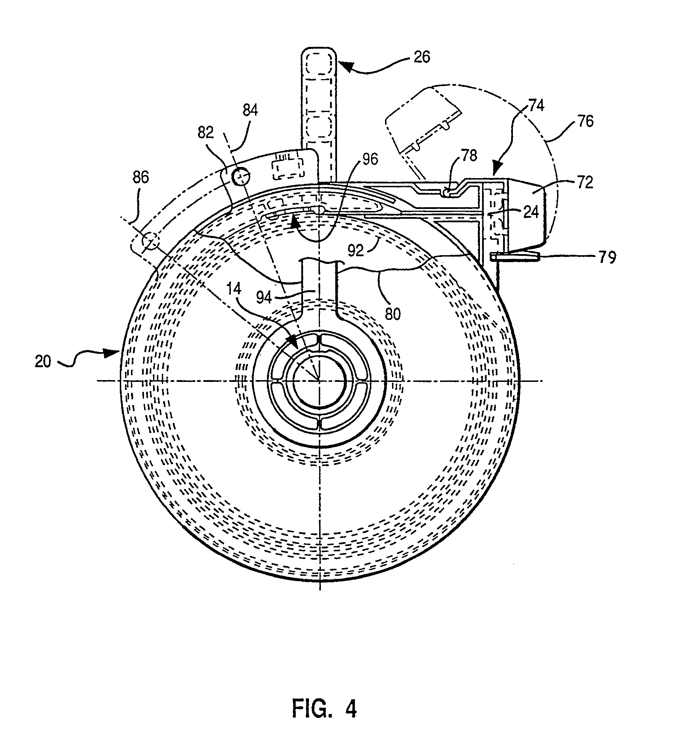

Still referring to Fig. 1, the spool 14 will preferably include a drive bushing 16 which may extend axially outwards from the spool 14 in both directions, as depicted in Fig. 2, although, in an alternate embodiment, only one such drive bushing 16 might be provided for, as desired. The housing 20 may actually be fashioned in a manner well known in the art into two half sections of a high impact plastic or the like which may be retainedly mated together to form the integral housing 20 by any of a number of conventional means well known in the plastic article manufacturing art, such as thermoforming or the like. The housing, if desired, may further include, as an integral component thereof, a tote handle 26 for convenience in transporting the cassette 10 to various locations throughout the manufacturing processes to be effected upon the strip 10 and to assist in installation and removal of the cassette 10 from various substrate processing apparatus, such as that shown in Fig. 5. It will be noted that an alternate embodiment of the handle 26 has been shown with respect to the cassette of Figs. 3 and 4, which is rotated 180 degrees from that of Fig. 1 and suspended from the drive bushing 16 from arms 94.

Referring now to Fig. 2, a side elevational view of the cassette 10 of Fig. 1 is shown depicted therein. The housing 20 will further include a slot 24 extending parallel to the axis 18 whereby, as shown in Fig. 1, the outermost layer of the strip coiled within the cassette 10 may protrude outwards thereof, such as shown by the pull tab 22 in Fig. 1. The cassette 10 may further be provided with a cap 72 hinged to the housing by means of hinge pin 78 whereby the cap 72 travels in an arc 76 about the pin 78. A latch pin 79 is further provided for securing the cap 72 in the position shown in Fig. 4. The slot 24 will preferably include a resilient sealing material, such as felt or the like, disposed along the inner edge of the slot. This material, as well as the cap 72, serves to provide a sealing function for the cassette 10 whereby the ambient and deleterious environment is precluded from entering into the cassette 10.

Still referring to Fig. 3, several features will be noted. It is a feature of the invention to provide for an inner coil of substrate 12 within the cassette 10 whereby each layer of the coil is separated by a desired radial distance 88. The purpose of this is to prevent damage to the substrate 12 as it is urged into coiling within the housing 10 and removal therefrom due to sliding friction on the fares of the substrate 12. Accordingly, in opposing faces of the cylinder defining the cassette 10, there will be disposed a respective spiral groove 92, both such grooves in both halves of the cassette 10 spiralling in the same direction about the axis 18, these grooves 92 in the inner faces of the opposing sides of the cylinder comprising the cassette 10 may be seen through the cut-away wall section 80 of Fig. 4. It will be appreciated that by introducing the strip of substrate 12 within the cassette 10 whereby opposing edges of the strip are introduced into respective grooves 92, and by continuing to introduce additional such material comprising the strip 12 into the cassette 10, that, accordingly, a coil of such substrate material 12 will thereby be formed suspended on the edges thereof by respective faces of the cylinder comprising the housing 20. More importantly, however, due to the spacing 88 between each of the grooves, each with a continuously increasing radial dimension, each layer of the substrate 12 housed within the cassette 10 will be spaced apart from adjacent such layers thereby avoiding damage to them during movement of the substrate within the cassette, either for filling the cassette or removing substrate therefrom. This spacing 88 will be sized in accordance with the particular requirements of the given substrate 12 in terms of its dimensional thickness, longitudinal compressibility and the like.

Referring now to Fig. 3, a sectional view an alternate embodiment of cassette 10 of Fig. 1 is shown taken through line 3-3 to show the internal construction of the cassette 10 and a more detailed view of the design of the spool 14 and drive bushing 16. It will be noted from Fig. 4 that the drive bushing 16 in the embodiment depicted therein is fashioned as shown, so as to facilitate engagement of the bushing with a drive means (not shown) of any suitable form. The drive serves the purpose of rotating the spool 14 to either facilitate feeding of the strip 12 outwards of the cassette 10 through the slot 24 or, in the alternative, facilitating take-up of the strip 12 through the slot 24 and on to the spool 14.

In some cases due to the incompressibility of particularly thin substrates 12 in the longitudinal direction and/or the length of such a strip 12 to be housed within the cassette 10, it may be difficult to urge the strip along the grooves 92 both during the process of loading the cassette 10 and removing the strip 12 therefrom. This may, in part, be due to the sliding friction between the outer edges of the strip 12 and the grooves 92, even though due to the spacing 88 much of the force impeding rotational movement of the substrate 12 has been eliminated. In such instances, it may be desirable to provide a mechanism for gripping the substrate 12 at short increments within the housing 20 for imparting an inward or outward force on the coil of substrate 12 within the housing 20. As but one example, an advancing mechanism 96 is provided in Fig. 4 which includes a lever 82 shown advancing to two different positions represented by center lines 84 and 86. The purpose of the advancing mechanism 96, thus, is to grasp opposing edges of the substrate 12 within the cassette whereby, by advancing the lever 82, such as by means of a mechanism interconnected to the bushing 16, or the like, the substrate 12 will be more readily advanced into and outwards of the housing 20.

In Fig. 6, a representative means for grasping the edges of the substrate 12 is shown, such as the advancing mechanism 96. A pair of balls 98 and 100 are provided on a opposing halves of the housing 20 disposed in races of housing 20 which further includes ramp-like surfaces 102 and 104. Edges of the substrate 12 are disposed between these balls 98, 100 and the ramp surfaces 102 and 104. It will be appreciated that by rotating the housing 20 counterclockwise, the balls 98, 100 will eventually engage the ramp surfaces 102 and 104, compressing the substrate 12 therebetween, whereby continued advancement of the lever 82 will cause the substrate to be carried with the rotating balls and ramp surfaces, compressed therebetween so as to force the substrate 12 into the coiled-like fashion within the housing 20. The advancing mechanism 96 on the opposing side of the housing 20 may be arranged in an opposite direction and move mechanically independently from the opposing respective such advancing mechanism 96. In this manner, rotation of this other lever 82 and corresponding drive bushing 16 may cause a moving of the substrate 12 in the opposing direction for purposes of withdrawing the substrate 12 from its coiled position within the housing 20.

Referring back now to Fig. 4 in more detail, a sectional view of the cassette 10 of Fig. 2 is shown taken along line 4-4.

Referring now to Fig. 5, a multi-tool substrate processing apparatus 50 is shown depicted therein for two purposes. First, such apparatus 50 is used to depict application of the cassettes 10 of the present invention in substrate processing and secondly to illustrate the novel substrate processing method itself of the invention. Referring to Fig. 5 in more detail, a substrate processing apparatus housing 56 is provided which may include one or more substrate sub-processing machines secured thereto, such as a punch 62, dielectric applicator 64 and repunch 66. It will be appreciated that the particular sub-processing apparatus 62-66 is a matter of choice dependent upon the operations which are desirably to be performed upon the substrate 12. Thus, the method of the invention is not intended to be so limited to any particular operations being performed on the substrate or apparatus for effecting same. Accordingly, if desired, only one sub-processing apparatus might be provided or additional apparatus for performing other functions conventionally employed in the manufacture of a high-density carrier circuit.

It is a feature of the substrate processing method of the invention to employ a continuous feed operation, and, thus, a plurality of cassettes 10 of the invention are provided, as shown by feed cassette 52 and take-up cassette 54. With the feed cassette 52 in place and, releasably interconnected to the housing 56, the substrate 12 contained therein is fed through suitable feed rollers 58 as required so as to registrate the substrate strip 12 through the processing apparatus 50 in the direction of arrow 70 and through the various sub-processing apparatus, such as the hereinbefore described punch 62 or the like. At the opposing end of the substrate processing apparatus 50, yet a second cassette forming the take-up cassette 54 is disposed. Again, this cassette is releasably attached to the housing 56 in any of a number of convenient manners. Take-up rollers 60 are further provided through which the substrate 12 is fed whereupon the substrate 12 thence exits the processing apparatus 50 and is introduced through the slot 24 of the take-up cassette 54. It will thus be appreciated that by rotation of the spools 14 of their respective cassettes 52 and 54 (as well as rotation of the feed and take-up rollers 58 and 60, respectively) in the direction of the arrows, as shown in Fig. 5, the substrate 12 will proceed to be unrolled from its internal location within feed cassette 52, and thence proceed through feed rollers 58, through substrate sub-processing apparatus 62-66, through take-up rollers 60 and thence such substrate 12 will be coiled up within take-up cassette 54.

As will be appreciated from the foregoing, one novel aspect of the processing apparatus 50 in the method for processing such substrates 12 lies in the readily removable feature of the feed and take-up cassettes 52 and 54 from the processing apparatus 50 itself. In this manner, the feed cassette 52 may include either raw substrate film 12 or such substrate film 12 which has had only intermediate processing steps performed thereupon. In either event, this film is readily stored and transportable in the feed cassette 52 while maintaining the integrity of the clean environment within the cassette 52. In like manner, upon effecting of the necessary substrate processing steps by the apparatus 50, this substrate will be automatically taken up by the take-up cassette 54 which may be readily removed for subsequent storage or transportation to yet additional substrate processing machines, such as additional apparatus 50 for effecting other steps necessary to production of a final high-density carrier substrate. In like manner to the feed cassette 52, the take-up cassette 54 also, accordingly, provides a clean and protected environment for the substrate 12 which has thus been processed by the processing apparatus 50.

## Claims

1. A container for high-density circuit substrate material for use with apparatus for processing said substrate, comprising support means for supporting said substrate material in the form of a coil and a housing for sealably housing said coil, said housing including means for retaining layers of said coil in radially spaced apart relation.

2. A container as claimed in Claim 1 wherein said housing includes a sealable slot through which a portion of said substrate material is extendable.

3. A container as claimed in claim 1 or claim 2 in which said further including a support means is a rotatable spool extending through said housing.

4. A container as claimed in any preceding claim wherein said housing means includes internal opposing faces each having disposed therein a spiral groove for supporting edges of said substrate within said housing.

5. A circuit substrate processing apparatus comprising a feed cassette including a coil of high-density substrate material; a take-up cassette including a coil of said high-density substrate material; and substrate processing means for processing said substrate material when extended between said feed and said take-up cassettes.

6. Apparatus as claimed in Claim 5 in which said substrate processing means is protected by a housing to which said feed and said take-up cassettes are releasably attachable.

7. Apparatus as claimed in Claim 5 or Claim 6 wherein said feed cassette and said take-up cassette each has a pair of opposed internal faces, each face having disposed therein a spiral groove for supporting edges of said substrate.

8. A method for processing a high-density circuit substrate on a substrate processing apparatus, comprising establishing a feed roll and a take-up roll of said high-density substrate; feeding a length of said high-density substrate from said feed roll to said take-up roll; and performing a substrate processing operation on said length of said high-density substrate while interconnected to said feed roll and said take-up roll.

9. A method as claimed in Claim 8 further including the steps of advancing said high-density substrate by rotation of said feed roll and said take-up roll; and performing a next substrate processing operation on said length of said high-density substrate.

10. A method as claimed in Claim 9 further including the steps of alternately repeating said advancing step and said performing of substrate processing operations until the substrate initially consistent said feed roll has been transferred to said take-up roll.

11. A method as claimed in any of Claims 8 to 10 in which said feed roll and said take-up roll are supported in cassettes releasably attached to said substrate processing apparatus.

12. A method as claimed in Claim 10 and Claim 11 including the further step of removing said take-up cassette roll from said processing apparatus upon transfer of said high-density substrate from said feed roll to said take-up roll to permit further processing in another apparatus.

FIG. 1

FIG. 2

| PUNCH | DIELECTRIC APPLICATION | RE-PUNCH |

FIG. 5

FIG. 6

FIG. 3

FIG. 4

European Patent
Office

# EUROPEAN SEARCH REPORT

Application Number

EP    91 30 3782

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | FR-A-2238247 (SOCIETE HONEYWELL BULL) <br> * page 5, line 27 - page 9, line 5; figure 3 * <br> --- | 1, 3, 5, 8, 9 | H01L21/00 |
| A | CA-A-1037237 (NORTHERN TELECOM LIMITED) <br> * page 3, line 25 - page 4, line 10; figure 1 * <br> ----- | 1, 3, 5, 8, 9 | |
| | | | **TECHNICAL FIELDS SEARCHED (Int. Cl.5 )** |
| | | | H01L <br> H05K |

The present search report has been drawn up for all claims

| Place of search | Date of completion of the search | Examiner |
|---|---|---|
| THE HAGUE | 31 JULY 1991 | RIEUTORT A.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P0401)